# EUROPÄISCHE PATENTSCHRIFT

(11) **EP 0 804 741 B1**
(45) Veröffentlichungstag und Bekanntmachung des Hinweises auf die Patenterteilung: **15.04.2009**
(21) Anmeldenummer: 96922760.2
(22) Anmeldetag: 10.07.1996
(51) Int. Cl.: G01R 31/00, F02D 41/22, F02M 25/08

(54) **VERFAHREN ZUR ÜBERPRÜFUNG VON FAHRZEUGTEILSYSTEMEN BEI KRAFTFAHRZEUGEN**
PROCESS FOR CHECKING PARTS OF MOTOR VEHICLE SYSTEMS
PROCEDE POUR CONTROLER DES SOUS-ENSEMBLES DE VEHICULES A MOTEUR

(30) Priorität: 03.11.1995 DE 19540943
(43) Veröffentlichungstag der Anmeldung: 05.11.1997
(73) Patentinhaber: ROBERT BOSCH GMBH, 70442 Stuttgart (DE)
(72) Erfinder: FELDMANN, Ekkehard, D-71282 Hemmingen (DE); FRECH, Eberhard, D-73230 Kirchheim (DE); SCHRAY, Bernhard, D-71739 Oberriexingen (DE); EDELMANN, Thomas, D-74321 Bietigheim-Bissingen (DE)
(86) Internationale Anmeldenummer: PCT/DE1996/001242
(87) Internationale Veröffentlichungsnummer: WO 1997/017618

(56) Entgegenhaltungen:
- EP-A- 0 553 472
- WO-A-90/13738
- DE-A- 4 333 009
- US-A- 4 267 569
- US-A- 5 005 129

## Beschreibung

### Stand der Technik

Die Erfindung betrifft ein Verfahren zur Überprüfung von Teilsystemen bei Kraftfahrzeugen, die mit On-Board-Diagnosesystemen ausgerüstet sind, am Ende des Fertigungsprozesses sowie bei Kundendiensten.

Moderne Kraftfahrzeuge sind aufgrund gesetzgeberischer Forderungen mit sogenannten On Board Diagnosesystemen ausgestattet. Mit Hilfe dieser Systeme wird die Funktionsfähigkeit von abgasrelevanten Fahrzeugteilsystemem überwacht. Ein Bsp. eines solchen Systems ist eine Tankentlüftungsanlage mit einem Aktivkohlefilter, einem steuerbaren Tankentlüftungsventil sowie den zugehörigen Leitungsverbindungen. Eine Vorrichtung zur On Board Diagnose eines Tankentlüftungsventils ist bspw. in der DE 36 24 441 dargestellt.

Es ist üblich, diese Systeme bei der ersten Inbetriebnahme des Fahrzeugs mit Hilfe der On Board Diagnose Funktionen zu überprüfen. Dazu wird unter definierten Bedingungen auf einem Prüfstand eine Fahrkurve aus Betriebspunkten mit vorbestimmten Werten von Last, Drehzahl und ggf. weiteren Parametern durchfahren, wobei die Fahrkurve so definiert ist, daß die On Board Diagnose Programme selbständig abgearbeitet werden. Wird dabei ein abgasrelevanter Fehler registriert, wird dies im Steuergerät als Fehlermeldung gespeichert und wahrend oder nach dem Prüflauf bspw. über einen externen Tester nach außen signalisiert, so dass Maßnahmen zur Beseitigung des Fehlers ergriffen werden können.

Das Auslesen von Selbsttestinformationen in Verbindung mit einer Bandendekontrolle ist bspw. aus den VDI Berichten 612, Seite 392 bekannt. Das dort vorgestellte System betrifft die Erweiterung bestehender Steuergeräte mit einer geeigneten Schnittstelle mit dem Ziel, die Informationen des Selbsttests des Steuergeräts bspw. einem Servicetechniker transparent zu machen.

Ein Diagnosesystem zum Überprüfen eines elektronischen Steuersystems zum Steuern insbesondere des Einspritzzeitpunktes und Zündzeitpunktes einer Brennkraftmaschine eines Kraftfahrzeugs ist aus der Druckschrift US 5 005 129 bekannt. Dieses Diagnosesystem umfasst ein elektronisches Steuersystem mit Selbstdiagnoseeinrichtungen, einen nicht-flüchtigen Speicher zum Speichern von Fehlerdaten als Resultat einer Selbstdiagnose durch die Selbstdiagnoseeinrichtungen, eine Diagnoseanordnung, die einen Computer mit einer Steuerungseinheit aufweist, und einen Speicher zum Speichern mehrerer Programme zum Untersuchen des elektronischen Steuersystems. Weiterhin umfasst das Diagnosesystem Verbindungsmittel zum Verbinden der Diagnoseanordnung mit dem elektronischen Steuerungssystem und Eingabemittel zum Eingeben einer Fehlercheckbetriebsart in einen Speicher. Ein Kommunikationssystem in der Diagnoseanordnung ist dazu ausgebildet, auf die eingegebene Fehlercheckbetriebsart ein Fehlerchecksignal an das elektronische Steuerungssystem zu senden und Fehlercheckbetriebsartbestimmungseinrichtungen im elektronischen Steuerungssystem, die auf das Fehlerchecksignal hin Fehlerdaten aus einem nicht-flüchtigen Speicher auslesen und an die Diagnoseeinrichtung senden.

Die Druckschrift US 4,267,569 betrifft eine Einrichtung zur Steuerung von Betriebsvorgängen in einem Kraftfahrzeug mit einem Mikrorechnersystem mit einem Mikroprozessor, der über ein Bussystem mit je wenigstens einem Festwertspeicher (ROM, PROM, EPROM), einem Arbeitsspeicher (RAM) sowie einer Eingabe/Ausgabe-Einheit verbunden ist, an die Signalgeber zur Erzeugung von betriebsparameterabhängigen Signalen sowie Stellglieder angeschlossen sind. Außerdem umfasst die Einrichtung Diagnosemittel zur Ermittlung und Kenntlichmachung von kraftfahrzeugspezifischen Defekten. Hierbei ist vorgesehen, dass die Diagnosemittel derart ausgebildet sind, dass sie durch Anlegen eines Signals an die Eingabe/Ausgabe-Einheit aktiviert werden und Diagnoseergebnisse und/oder kraftfahrzeugspezifische Daten an eine an die Einrichtung anschließbare externe Diagnoseauswerteeinrichtung ausgebbar sind.

Mit dem Durchfahren einer zur Auslösung und Durchführung der On Board Diagnose Funktionen ausreichenden Fahrkurve ist ein hoher Zeitaufwand verbunden, da die für den Alltagsbetrieb ausgelegten Diagnosefunktionen bspw. erst nach Ablauf einer gewissen Zeitspanne nach dem Start des Fahrzeugs vom Steuergerät ausgelöst werden. Diese Zeitspanne kann im Minutenbereich liegen, was für einen Bandendetest eine sehr lange Zeitspanne darstellt.

Die Aufgabe der Erfindung besteht in der Angabe einer Vorrichtung, die zur Verkürzung dieser Prüfzeit unter Beibehaltung des Ausnutzens der in der bekannten Vorrichtung implementierten On Board Diagnosefunktionen. Diese Aufgabe wird mit den Merkmalen des Anspruchs 1 gelöst.

Die erfindungsgemäße Vorrichtung ermöglicht eine einfache Funktionsüberprüfung von Teilsystemen wie Sekundärlufteinblasung und Tankentlüftung unter Einbeziehung aller relevanten Komponenten mit reduzierter Prüfzeit. Das Ausnutzen bestehender Diagnosefunktionen erspart die Implementation eigenständiger, nur für die Bandende- oder Kundendienstprüfung vorgesehener Diagnosefunktionen. Damit geht eine Verringerung des Programmieraufwandes sowie eine insgesamt optimierte Struktur des Steuerprogramms der Diagnosevorrichtung einher. Dabei ist die Vorrichtung darüber hinausgehend so programmierbar, dass die Startbedingungen, unter denen die Diagnose ausgelöst wird, durch ein Signal vom Tester umgangen werden.

Ein Ausführungsbeispiel der Erfindung wird im folgenden mit Bezug auf die Zeichnungen beschrieben.
- Fig. 1: zeigt eine Brennkraftmaschine mit einer Tankentlüftungsanlage und einem Sekundärluftsystem als Bsp. von Teilsystemen, die mit On Board Mitteln zu prüfen sind.
- Fig. 2: zeigt ein Ausführungsbeispiel von Verfahrensschritten, durch die das Steuergerät 4 aus der Fig. 1 als erfindungsgemäße Vorrichtung arbeitet.

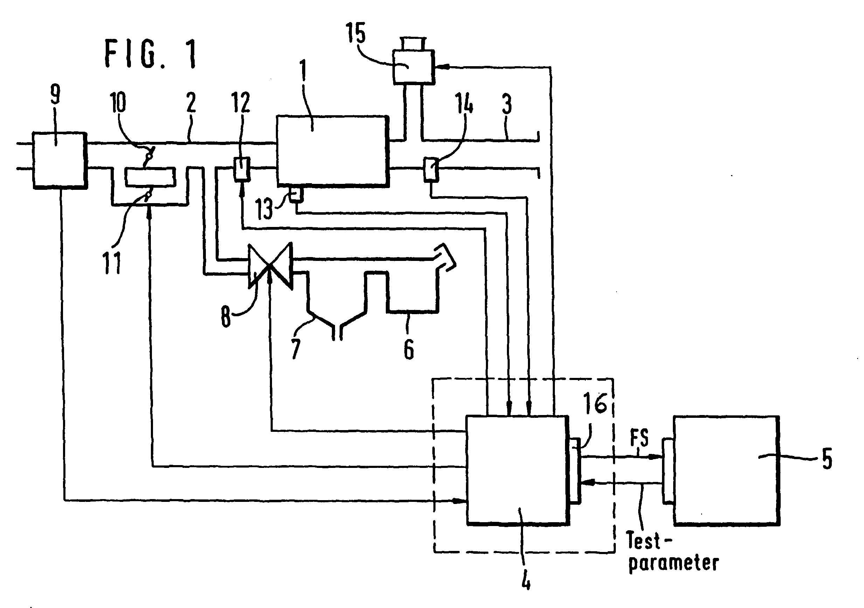

Die 1 in der Fig. 1 bezeichnet eine Brennkraftmaschine mit einem Saugrohr 2, einem Abgasrohr 3, einer Tankentlüftungsanlage, einem Sekundärluftsystem 15 und einem Steuergerät 4 sowie einem externen Testgerät 5.

Die Tankentlüftungsanlage umfasst einen Tank 6, einen Aktivkohlefilter 7 und ein Tankentlüftungsventil 8.

Im Saugrohr 2 sind Mittel 9 zum Erfassen der von der Brennkraftmaschine angesaugten Luftmenge m, eine Drosselklappe 10, ein Bypass zur Drosselklappe mit einem Leerlaufstellglied 11 sowie ein Kraftstoffzumessmittel 12 angebracht.

Stellvertretend für weitere Sensoren zur Erfassung von Betriebskenngrößen der Brennkraftmaschine ist ein Drehzahlsensor 13 an der ,Brennkraftmaschine sowie ein Abgasmessfühler 14 im Abgasrohr der Brennkraftmaschine dargestellt.

Ein externes Testgerät 5 kommuniziert über eine Schnittstelle 15 mit dem Fahrzeugsteuergerät 4.

Zwischen den dargestellten Sensoren und Stellgliedern vermittelt das Steuergerät 4 in vorprogrammierter Weise. So wird bspw. die Menge m der angesaugten Luft durch Division durch die Drehzahl n der Brennkraftmaschine auf einzelne Hübe normiert und daraus ein Basiswert zur Ansteuerung des Kraftstoffzumeßmittels 12 gebildet. Dieser Basiswert wird abhängig vom Signal des Abgasmeßfühlers 14 so korrigiert, daß sich im zeitlichen Mittel ein gewünschter Wert der Zusammensetzung Lambda des in der Brennkraftmaschine verbrannten Kraftstoff/Luft-Gemisches einstellt. Parallel zu diesem Gemischregelkreis arbeitet ein Leerlaufregelkreis aus Drehzahlsensor und Leerlaufstellglied 11. Sinkt die Drehzahl unter einen Sollwert ab, erhöht das Steuergerät 4 über den Leerlaufsteller die von der Brennkraftmaschine angesaugte Luftmenge und steigert damit deren Drehzahl.

Im Tank 6 verdunsteter Kraftstoff wird im Aktivkohlefilter 7 zwischengespeichert. Im Fahrbetrieb wird das Tankentlüftungsventil 8 nach Steueranweisungen des Steuergerätes 4 geöffnet, so daß über das Aktivkohlefilter Luft angesaugt wird, die den zwischengespeicherten Kraftstoff mitreißt und der Verbrennung zuführt.

Das Tankentlüftungssystem funktioniert bspw. bei defekt geschlossenem Tankentlüftungsventil nicht. Um diesen Fehler mit On Board-Mitteln zu entdecken, ist es bekannt, das Tankentlüftungsventil maximal zu öffnen und die Reaktion des Lambda und/oder Drehzahlregelkreises zu bewerten. Bei intaktem Tankentlüftungsventil und mit Kraftstoff beladenem Aktivkohlefilter ruft die öffnende Ansteuerung des Tankentlüftungsventils eine Anfettung des der Brennkraftmaschine zugeführten Kraftstoff/Luft-Gemisches hervor, die über den Abgasmeßfühler registriert wird. Bei nicht mit Kraftstoff beladenem Aktivkohlefilter wird im Extremfall über das Tankentlüftungsventil reine Luft angesaugt, was bei ausgeschalteter Leerlaufdrehzahlregelung zu einem Anstieg der Drehzahl führt. Tritt weder eine Lambda- noch eine Drehzahlreaktion auf, wird dies als Fehler gewertet und bspw. eine diesen Fehler anzeigende Fehlermeldung ausgegeben oder abgespeichert.

Das Sekundärluftsystem kann bspw. dadurch überprüft werden, daß die Reaktion der Lambdassonde auf ein Einblasen von Luft beobachtet wird. Diese On Board Diagnoseprogramme werden im Normalbetrieb vom Steuergerät 4 beim Vorliegen bestimmter Startbedingungen ausgelöst.

So kann bspw. vorgesehen sein, diese Prüfung im Alltagsbetrieb erst einige Zeit nach dem Start der Brennkraftmaschine auszuführen, was bei einer Nutzung der On-Board-Diagnose am Bandende zu einem unerwünschten Zeitaufwand führt.

Zur Verkürzung des Testverfahrens am Bandende oder bei einem Kundendienst wird erfindungsgemäß die Diagnosevorrichtung so ausgestaltet, daß ihr ein Signal eingekoppelt werden kann, durch das die Auslösung und/oder der Ablauf der Diagnosefunktionen modifiziert werden.

Ein bekanntes, OBD-fähiges Steuergerät weist eine Schnittstelle auf, über die Daten, z.B. während des Diagnoseablaufs aufgetretene Fehlermeldungen an einen externen Tester weitergegeben werden. Die erfindungsgemäße Vorrichtung ist darüberhinausgehend so programmiert, daß die Startbedingungen, unter denen die Diagnose ausgelöst wird, durch ein Signal vom Tester umgangen werden können. Zusätzlich kann vorgesehen sein, den Ablauf des Diagnoseverfahrens durch Ändern bestimmter Testparameter zu modifizieren.

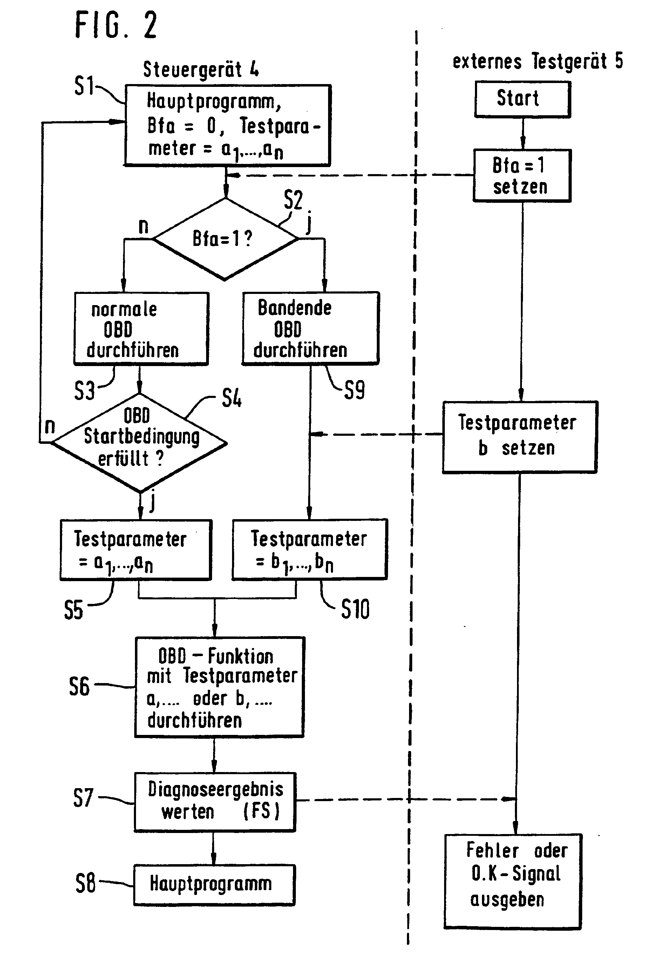

Ein Ausführungsbeispiel der erfindungsgemäßen Vorrichtung arbeitet auf die in der linken Hälfte der Fig. 2 dargestellte Weise. Die rechte Hälfte veranschaulicht Verfahrensschritte, die während der Arbeit der erfindungsgemäßen Vorrichtung parallel in einem externen Testgerät ablaufen, das über eine Schnittstelle mit der Erfindungsgemäßen Vorrichtung verbunden ist.

Nach dem Start der Brennkraftmaschine arbeitet das Steuergerät in einem Hauptprogramm (Block S1), in dem bspw. Vorgänge wie das Auslösen der Zündung und Einspritzzeitberechnungen koordiniert werden.

Im Alltagsbetrieb schließen sich folgende Schritte an: Eine Variable Bfa, die Werte Null oder Eins annehmen kann, besitzt nach dem Start den Standardwert Null und ein Satz von Testparametern besitzt Standardwerte a1,...,an. In einem Schritt S2 wird geprüft, ob die Variable Bfa den Wert Eins besitzt. Im Alltagsbetrieb wird diese Abfrage verneint, was als Eingangsvoraussetzung (Schritt S3) für die übliche On-Board-Diagnose gewertet wird. Anschließend wird im Schritt S4 geprüft, ob bestimmte Startbedingungen für die Auslösung der On-Board-Diagnose erfüllt sind. Beispiele solcher Bedingungen sind das Vorliegen einer Mindestkühlwassertemperatur, des Ablaufs einer gewissen Zeitspanne nach dem Start der Brennkraftmaschine usw. Solange diese Bedingungen nicht erfüllt sind, wird in das Hauptprogramm zurückgekehrt. Sind diese Bedingungen dagegen erfüllt, wird in einem Schritt S5 der Satz Testparameter al, ..., an eingelesen und in einem Schritt S6 wird die normale OBD-Funktion mit diesen Testparametern durchgeführt. Das Ergebnis der Diagnose wird im Schritt S7 gewertet, in dem bei schwerwiegenden Fehlern eine Fehlerlampe MIL eingeschaltet wird oder aber bei weniger schwerwiegenden Fehlern ein Fehlerzählerstand erhöht wird.

Im Schritt S8 wird anschließend das Hauptprogramm fortgesetzt.

Im Fall einer Bandendeprüfung wird dem Steuergerät 4 über eine Schnittstelle 16 vom externen Testgerät 5 ein Signal eingekoppelt, mit dem der Wert der Variablen Bfa im Steuergerät vom Wert Null auf den Wert Eins geändert wird (Schritt T1). Die anschließende Abfrage im Schritt S2 wird dann bejaht, worauf das Steuergerät in einen Bandende-Diagnose-Modus verzweigt (Schritt S9). Dieser Zweig umgeht die Startbedingungen, an die die Diagnose im Alltagsbetrieb geknüpft ist. Falls gewünscht, können in diesem Zweig auch Testparameter geändert werden. Dazu dient der Schritt T2, in dem das externe Testgerät einen geänderten Satz von Testparametern b1,...,bn im Steuergerät 4 aktiviert oder an das Steuergerät übergibt. Das Steuergerät 4 arbeitet jedenfalls mit diesem geänderten Satz (Schritt S10) im Schritt S6 die ansonsten unveränderte OBD-Funktion ab. Treten dabei Fehler auf, werden diese im Schritt S7 festgestellt und dem externen Tester signalisiert.

Angewandt auf die oben dargestellte OBD-Funktion zur Prüfung eines Tankentlüftungsventils kann auf diese Weise die Prüfung unter Umgehung von Wartezeiten verzögerungslos vom Testgerät 5 ausgelöst werden. Um wechselseitige Beeinflussungen mit anderen OBD-Funktionen zu anderen Fahrzeugteilsystemen auszuschließen, kann das vom Testgerät 5 eingekoppelte Signal auch dazu dienen, die selbständige Auslösung von OBD-Funktionen seitens des Steuergerätes zu unterdrücken. Die Erfindung ist nicht auf eine Diagnose der Tankentlüftung oder der Sekundärlufteinblasung beschränkt sondern kann prinzipiell in Verbindung mit jeder OBD-Funktion anderer Teilsysteme verwendet werden. Beispiele anderer hierfür in Frage kommender Teilsysteme sind das Kraftstoffversorgungssystem, eine Katalysatorüberwachung, eine Überwachung der Lambdasonde auf Alterung, das Lasterfassungssystem, ein System zur Erkennung von Verbrennungsaussetzern, eine Diagnose von Sensoren. Wesentlich ist vor allem, daß die On-Board-Diagnosefunktion unabhängig von sonstigen Startbedingungen von einem externen Testgerät auslösbar und ggf. in ihrem Ablauf modifizierbar ist.

## Patentansprüche

1. On Board Diagnose Vorrichtung zum Überprüfen von Teilsystemen eines Kraftfahrzeugs durch im Betrieb des Kraftfahrzeugs unter vorbestimmten Startbedingungen ausgelöste Testfunktionen,
wobei wenigstens ein Signal von einem externen Testgerät (5) in die Vorrichtung einkoppelbar ist, durch das
die Auslösung von Testfunktionen seitens der Vorrichtung gesperrt wird,
und durch das wenigstens eine von der Vorrichtung durchgeführte Testfunktion unabhängig von den vorbestimmten Startbedingungen auslösbar und/oder in Ihrem Ablauf modifizierbar ist,
**dadurch gekennzeichnet, dass**
die Vorrichtung darüber hinausgehend so programmiert ist, dass die Startbedingungen, unter denen die Diagnose ausgelöst wird, durch ein Signal vom Testegerät (5) umgangen werden können.

2. Vorrichtung nach Anspruch 1, **dadurch gekennzeichnet, dass** das Teilsystem ein Tankentlüftungssystem ist.

3. Vorrichtung nach Anspruch 1, **dadurch gekennzeichnet, dass** das Teilsystem ein Sekundärluftsystem ist.

4. Vorrichtung nach Anspruch 1, **dadurch gekennzeichnet, dass** das Teilsystem ein Kraftstoffversorgungssystem, ein System zur Überwachung des Katalysators, der Lambdasonde auf
Alterung, ein Lasterfassungssystem, ein System zur
Aussetzererkennung oder ein System zur Diagnose eines Sensors ist.

## Claims

1. On-board diagnostic device for checking parts of motor vehicle systems by means of test functions which are triggered under predetermined starting conditions while the motor vehicle is operating,
wherein at least one signal can be fed into the device from an external test unit (5), by means of which signal
the triggering of test functions by the device is disabled,
and by means of which at least one test function which is carried out by the device can be triggered independently of the predetermined starting conditions and/or modified in its sequence,
**characterized in that**
the device is also programmed in such a way that the starting conditions under which the diagnosis is triggered can be bypassed by means of a signal from the test unit (5).

2. Device according to Claim 1, **characterized in that** the part of the system is a fuel tank venting system.

3. Device according to Claim 1, **characterized in that** the part of the system is a secondary air system.

4. Device according to Claim 1, **characterized in that** the part of the system is a fuel supply system, a system for monitoring the catalytic converter, the lambda probe for ageing, a load-sensing system, a system for detecting misfires or a system for diagnosing a sensor.

## Revendications

1. Dispositif de diagnostic embarqué pour contrôler des systèmes partiels d'un véhicule automobile par des fonctions de test déclenchées pendant le fonctionnement du véhicule sous des conditions de démarrage prédéfinies, au moins un signal pouvant être injecté dans le dispositif depuis un appareil de test externe (5), signal par le biais duquel le déclenchement de fonctions de test est bloqué du côté du dispositif et par le biais duquel au moins une fonction de test exécutée par le dispositif peut être déclenchée par les conditions de démarrage prédéfinies et/ou son déroulement peut être modifié,
**caractérisé en ce que**
le dispositif est en plus programmé de telle sorte que les conditions de démarrage sous lesquelles est déclenché le diagnostic peuvent être contournées par un signal de l'appareil de test (5).

2. Dispositif selon la revendication 1, **caractérisé en ce que** le système partiel est un système de purge de réservoir.

3. Dispositif selon la revendication 1, **caractérisé en ce que** le système partiel est un système de ventilation secondaire.

4. Dispositif selon la revendication 1, **caractérisé en ce que** le système partiel est un système d'alimentation en carburant, un système de surveillance du vieillissement du catalyseur, de la sonde Lambda, un système de détection de charge, un système de détection d'exposition ou un système de diagnostic d'un capteur.
